# EUROPEAN PATENT SPECIFICATION

(11) **EP 1 377 150 B1**
(45) Date of publication and mention of the grant of the patent: **08.08.2007**
(21) Application number: 03022559.3
(22) Date of filing: 24.01.2001
(51) Int. Cl.: H05K 9/00, H01F 1/00, H01F 10/00

(54) **Magnetic substance with maximum complex permeability in quasi-microwave band and method for production of the same**
Magnetmaterial mit Maximum-Komplex-Permeabilität in quasi-Mikrowellenbereich und Herstellungsverfahren
Substance magnétique à perméabilité complexe maximale dans une bande de quasi-hyperfréquences et procédé de production

(30) Priority: 24.01.2000 JP 2000052507
(43) Date of publication of application: 02.01.2004
(62) Divisional of application: 01901523.9
(73) Proprietor: Nec Tokin Corporation, Sendai-shi, Miyagi (JP)
(72) Inventor: Yoshida, Shigeyoshi, Taihaku-ku Sendai-shi Miyagi (JP); Ono, Hiroshi, Taihaku-ku Sendai-shi Miyagi (JP); Andoh, Shinsuke, Taihaku-ku Sendai-shi Miyagi (JP); Li, Wei-Dong, Taihaku-ku Sendai-shi Miyagi (JP); Shimada, Yutaka, Sendai-shi Miyagi 981-0961 (JP)
(74) Representative: Hofer, Dorothea

(56) References cited:
- EP-A- 0 991 087
- DATABASE WPI Section Ch, Week 199738 Derwent Publications Ltd., London, GB; Class L03, AN 1997-408936 XP002260153 & JP 09 181476 A (MITSUI MINING & SMELTING CO LTD), 11 July 1997 (1997-07-11)
- HAN S H ET AL: "SOFT MAGNETIC PROPERTIES OF FE-(SI3N4, AL2O3) THIN FILMS" IEEE TRANSACTIONS ON MAGNETICS, IEEE INC. NEW YORK, US, vol. 32, no. 5, 1 September 1996 (1996-09-01), pages 4499-4501, XP000634050 ISSN: 0018-9464

## Description

### Technical Field of the invention

This invention relates to a noise suppressor for use in suppression or absorption of a high frequency noise in an electric and electronic apparatus and, in particular, to such a noise suppressor adapted for use in suppression of electromagnetic interference (EMI) caused in an active electronic element, a high frequency circuit component, and a high frequency electronic apparatus.

### Technical Background

It is well known in the art that a cylindrical ferrite core is attached onto an electric power cord to an electronic apparatus, for example, computer so as to suppressing a high frequency noise from flowing into, or from, the computer through the electric power cord. The ferrite core absorbs the high frequency noise current flowing through the power cord. The ferrite core used has a large volume in comparison with electronic apparatus which have rapidly been small-sized with electronic circuit components disposed at a high density.

It is also well known in the art that a concentrated constant circuit such as a decoupling capacitor is assembled in a power circuit line in the electronic apparatus so as to suppressing undesired radiation from the power line.

It is also another problem that a high frequency noise is often caused by or induced from a semiconductor or an integrated circuit device of a high speed operation type such as a random access memory (RAM), a read only memory (ROM), a microprocessor (MPU), a central processing unit (CPU), or an image processor arithmetic logic unit (IPALU) because an electric signal flows in a high speed circuit therein with rapid change in current and voltage value.

In addition, electronic elements and cables are disposed with a high density in a small-sized electronic apparatus. Therefore, those elements and lines are very close to each other and thereby affected to each other to cause the EMI.

In order to suppress the high frequency noise from those semiconductor devices and the EMI within the small-sized electronic apparatus, the conventional ferrite core cannot be used because it has a relatively large volume.

On the other hand, use of the concentrated constant circuit cannot sufficiently suppress the high frequency noise caused in the circuit using electronic elements of the high speed operation type because the noise has an increased frequency so that the circuit line actually acts as a distributed constant circuit.

JP-A 10-97913 discloses a complex magnetic substance having a relatively large core loss or complex permeability. The complex magnetic substance is disposed adjacent a semiconductor device and/or electronic circuit device and can suppress a high frequency noise radiated therefrom.

JP 09 181 476 A discloses a radio wave absorber consisting of a super fine crystal magnetic film made up by a ceramic phase and a super fine crystal phase. The magnetic film may have a composition of Fe-Al-O. The maximum of the complex permeability lays in a range of 0.01-1 GHz.

It is understood from the recent research that use of the magnetic substance having the complex permeability µ" is considered as an effective resistance added to the circuit generating the noise so that the noise can be attenuated. The effective resistance is dependent on the complex permeability *µ*" of the magnetic substance used. In detail, providing that the magnetic substance has a constant area, it is certain that the effective resistance is dependent on the complex permeability µ" and the thickness of the magnetic substance. This means that magnetic substance having an increased complex permeability could provide a high frequency noise suppressor with a reduced volume, that is, a reduced size in area and thickness, which could be assembled within a small-sized apparatus.

### Summary of the Invention

According to this invention, a noise suppressor according to claim 1 can be obtained.

Further, according the invention, the noise suppressor according to dependent claims 2-10; is obtained.

As the magnetic substance having a low core loss and a high saturation magnetization, a M-X-Y magnetic composition (M: magnetic metallic element, Y: O, N, or F, X: element or elements other than M and Y) is known in the prior art, which is mainly produced by the sputtering method or the vapor deposition method and has a granular structure where metallic magnetic particles of M are dispersed in a non-magnetic matrix (X and Y)like ceramics.

During searching fine structures of the M-X-Y magnetic composition having the excellent permeability, the present co-inventors found out that the high saturation magnetization can be realized in a high concentration region of M where the M-X-Y magnetic composition has a saturation magnetization of 60-80% of that of the metallic bulk of magnetic material comprising M alone..

The M-X-Y magnetic composition has a low specific resistance. Therefore, when it is formed in a part having a relatively thickness which is used in a high frequency range, the part permits an eddy current to flow therein. As a result, the part is reduced in permeability. Therefore, the conventional M-X-Y magnetic composition having the high saturation magnetization cannot be used for part having an increased thickness.

The present inventors further found out that the M-X-Y magnetic composition having a reduced concentration of M has an increased complex permeability µ" in a high frequency range. In a reduced concentration region of M where the M-X-Y magnetic composition has a saturation magnetization of 60-80% of that of the metallic bulk of magnetic material comprising M lone, the M-X-Y magnetic composition has a relatively high specific resistance of about 100 µ · Ω · cm or more. Therefore, if a part having a thickness such as several micrometers (µm) is formed of the composition with the reduced concentration of M, it shows a reduced loss due to the eddy current. The core loss or complex permeability is a loss due to the natural resonance. Therefore, the distribution of the complex permeability on a frequency axis is narrow. This means that the M-X-Y magnetic composition with the reduced concentration of M is useful for suppression of noise within a narrow frequency range.

In design of a part made of magnetic substance to be disposed adjacent an electronic circuit so as to suppress a high frequency noise, a value of a product (µ" · δ) of the complex permeability µ*"* and a thickness δ of the magnetic substance is considered. Generally, (*µ*" · δ) ≧ 1000 *µ*m is required for effectively suppressing high frequency noise of hundreds megahertz (MHz). When the magnetic composition used has the complex permeability of about 1000 (µ"=1000), the noise suppressor is required to have a thickness of 1 micrometer (µm) or more. Therefore, the composition having a low specific resistance is not desired because the eddy current is easily generated but is desired to have an increased specific resistance such as 100 µ · Ω · cm or more.

In the view point of the above, M-X-Y composition used for the noise suppressor is desired to have a reduced concentration of M where the M-X-Y magnetic composition has a saturation magnetization of 60-80% of that of the metallic bulk of magnetic material comprising M alone.

### Brief Description of the Drawing

Fig. 1 is a schematic view showing a granular structure of M-X-Y magnetic composition;
Fig. 2A is a schematic sectional view showing a structure of a sputtering apparatus which was used in examples;
Fig. 2B is a schematic sectional view showing a structure of a vapor deposition apparatus which was used in examples;
Fig. 3 is a graphical view showing a frequency response of a complex permeability of film sample 1 in Example 1;
Fig. 4 is a graphical view showing a frequency response of a complex permeability of film sample 2 in Example 2;
Fig. 5 is a graphical view showing a frequency response of a complex permeability of comparable sample 1 in Comparable Example 1;
Fig. 6 is a schematic and perspective view of a test apparatus for testing an noise suppressing effect of magnetic samples;
Fig. 7A is a graphic view showing a transmission characteristic of film sample 1;
Fig. 7B is a graphic view showing a transmission characteristic of comparable sample of composite magnetic material sheet;
Fig. 8A is a distribution constant circuit with a length ℓ showing a magnetic material as a noise suppressor;
Fig. 8B is an equivalent circuit with a unit length Δℓ of the distribution constant circuit of Fig. 8A;
Fig. 8C is an equivalent circuit with a length ℓ of the distribution constant circuit of Fig. 8A;
Fig. 9A is a graphic view showing a frequency response of an equivalent resistance R of film sample 1 in Example 1; and
Fig. 9B is a graphic view showing a frequency response of an equivalent resistance R of comparative sample of a composite magnetic material sheet.

### Embodiments of the Invention

At first, description will be made as to granular structure and production methods of M-X-Y magnetic composition.

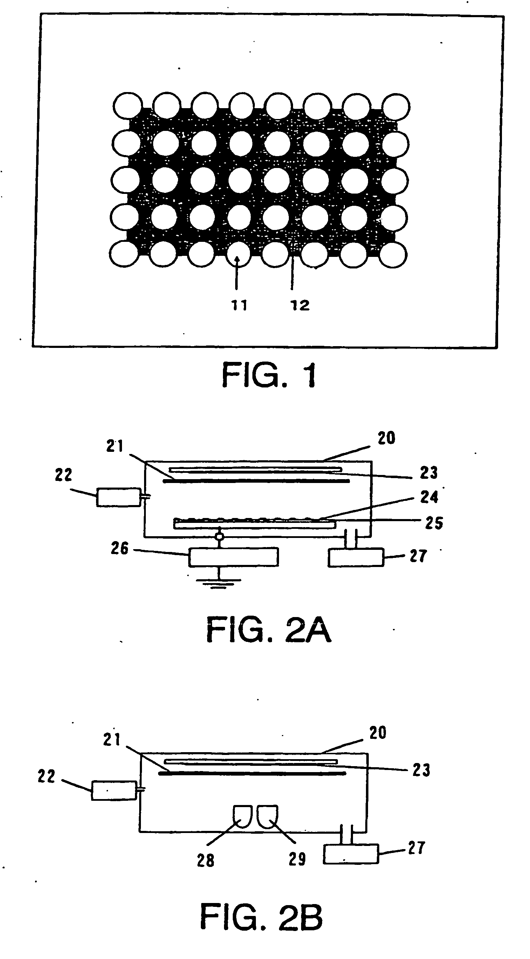

Referring to Fig. 1 in which schematically shows the granular structure of M-X-Y magnetic composition, particles 11 of metallic magnetic material M are uniformly or evenly distributed in a matrix 12 consisting of X and Y.

Referring to Fig. 2A, a sputtering apparatus shown therein was used for producing samples in the following examples and comparative examples. The sputtering apparatus has a conventional structure and comprises a vacuum container 20, a shutter 21, an atmospheric gas source 22, a substrate or a glass plate 23, chips 24 (X or X-Y), a target 25 (M), an RF power source, and a vacuum pump 27. The atmospheric gas source 22 and the vacuum pump 27 are connected to the vacuum container 20. The substrate 23 confronts to the target 25 on which chips 24 are disposed. The shutter 21 is disposed in front of the substrate 21. The RF power source 26 is connected to the target 25.

Referring to Fig. 2B, a vapor deposition apparatus shown therein was also used another apparatus for producing samples in the following examples and comparative examples. The vapor deposition apparatus has a conventional structure and has vacuum container 20, atmospheric gas source 22, and vacuum pump 27 similar to the sputtering apparatus but has crucibles 28 and 29 including materials (X-Y) in place of chips 24, target 25 and RF power source 26.

### Example 1

A thin film of M-X-Y magnetic composition was made on a glass plate by use of the sputtering apparatus shown in Fig. 2A at a sputtering condition shown in Table 1.

**Table 1**

| | |
|---|---|
| Vacuum degree before sputtering | <1 × 10⁻⁶ Torr (<1.33 × 10⁻⁴ Pa) |
| Atmosphere | Ar gas |
| Electric Power | RF |
| Targets | Fe (diameter of 100mm) and Al₂O₃ chip (120 pieces) (chip size: 5mm × 5mm × 2mm) |

The film sample 1 produced was analyzed by a fluorescent X-ray spectroscopy and confirmed as a film of a composition Fe₇₂Al₁₁O₁₇. The film sample 1 had 2.0 micrometer (µm) in thickness, 530 micro ohm centimeters (µΩ · cm) in DC specific resistance, 18 Oe (1.433 × 10³ A/m) in anisotropy field (Hk), and 16,800 Gauss (1,68 T) in saturation magnetization (Ms).

A percent ratio of the saturation magnetization of the film sample 1 and that of the metallic material M itself {Ms(M-X- Y)/Ms(M)} × 100 was 72.2%.

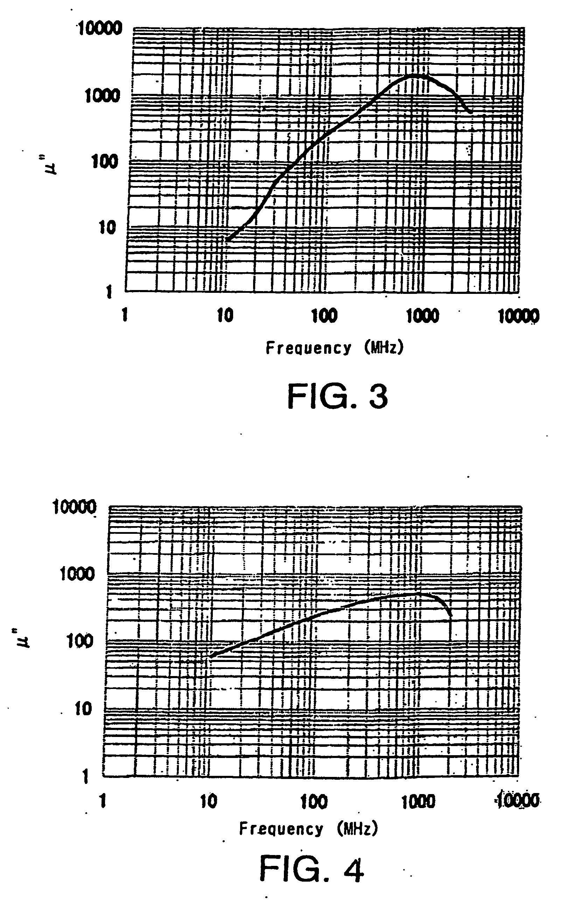

In order to measure a permeability frequency response, the film sample 1 was formed in a ribbon like form and inserted in a coil. Under application of a bias magnetic field, an impedance variation of the coil was measured in response to frequency change ofAC current applied to the coil. The measurement was several times for different values of the bias magnetic field. From the measured impedance variation in response to frequency variation, the complex permeability frequency response (µ "-f response) was calculated and is shown in Fig. 3. It will be noted from Fig. 3 that the complex permeability has a high peak or the maximum value (µ"ₘₐₓ) and rapidly falls either side of the peak. The natural resonance frequency (f(µ"ₘₐₓ)) showing the maximum value (µ"ₘₐₓ) is about 700 MHz. From the µ"-f response, a relative bandwidth bwr was determined as a percentage ratio of bandwidth between two frequency points which shows the complex permeability as a half value *µ*"₅₀ of the maximum µ"ₘₐₓ, to center frequency of said bandwidth. The relative bandwidth bwr was 148%.

### Example 2 (not forming part of the invention)

In a condition similar to that in Example 1 but using of 150 Al₂O₃ chips, a film sample 2 was formed on a glass plate.

The film sample 2 produced was analyzed by a fluorescent X-ray spectroscopy and confirmed as a film of a composition Fe₄₄Al₂₂O₃₄. The film sample 2 had 1.2 micrometer (µm) in thickness, 2400 micro ohm centimeters (µΩ · cm) in DC specific resistance, 120 Oe (9.55 × 10³ A/m) in anisotropy field (Hk), and 9600 Gauss (0,96 T) in saturation magnetization (Ms). It will be noted that film sample 2 is higher than film sample 1 in the specific resistance.

A percent ratio of the saturation magnetization of the film sample 2 and that of the metallic material M itself {Ms(M-X-Y)/Ms(M)} × 100 was 44.5%.

The µ "-f response of film sample 2 was also obtained in the similar manner as in Example 1 and shows in Fig. 4. It is noted that the peak has also a high value similar to that in film sample 1. However, the frequency point at the peak, or the natural resonance frequency is about 1 GHz and the complex permeability gradually falls either side of the peak so that the µ "-f response has a broadband characteristic.

A relative bandwidth bwr of film sample 2 was also confirmed as 181 % by the similar way as in Example 1.

### Comparative Example 1

In a condition similar to that in Example 1 but using of 90 Al₂O₃ chips, a comparative sample 1 was formed on a glass plate.

The comparative sample 1 produced was analyzed by a fluorescent X-ray spectroscopy and confirmed as a film of a composition Fe₈₅Al₆O₈. The comparative sample 1 had 1.2 micrometer (µm) in thickness, 74 micro ohm centimeters (µΩ · cm) in DC specific resistance, 22 Oe (1.751 × 10³ A/m) in anisotropy field (Hk), 18,800 Gauss (1.88 T) in saturation magnetization (Ms), and 85.7% in a percent ratio of the saturation magnetization of the comparative sample 1 and that of the metallic material M itself {Ms(M-X-Y)/Ms(M)} × 100.

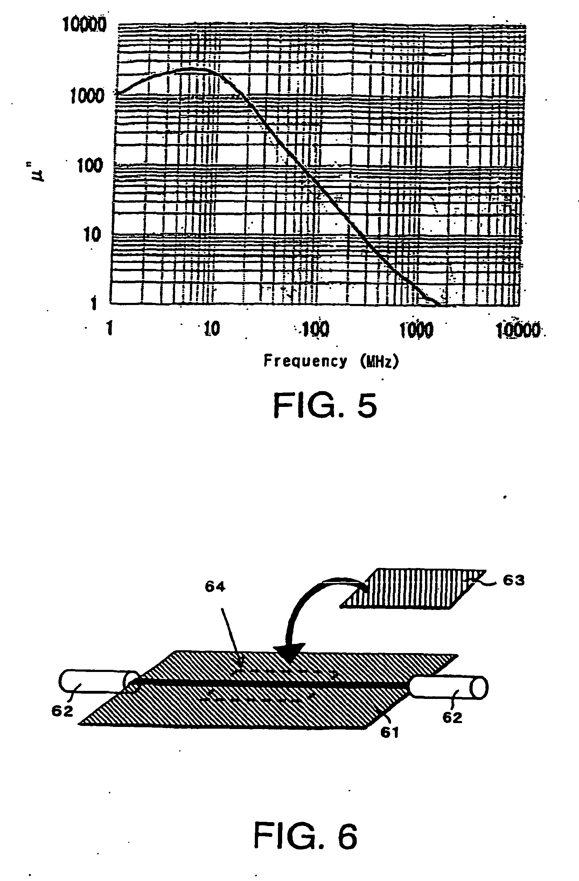

The µ"-f response of comparative sample 1 was also obtained in the similar manner as in Example 1, and is shown in Fig. 5. It will be noted from Fig. 5 that the complex permeability µ" of the comparative sample 1 has a high peak at a frequency about 10 MHz but rapidly reduces at the higher frequency range than 10 MHz. It can be supposed that this reduction is caused by generation of eddy current due to the lower specific resistance.

### Comparative Example 2

In a condition similar to that in Example 1 but using of 200 Al₂O₃ chips, a comparative sample 2 was formed on a glass plate.

The comparative sample 2 produced was analyzed by a fluorescent X-ray spectroscopy and confirmed as a film of a composition Fe₁₉Al₃₄O₄₇. The comparative sample 2 had 1.3 micrometer (µm) in thickness, 10,500 micro ohm centimeters (µΩ · cm) in DC specific resistance.

The magnetic characteristic of comparative sample 1 exhibited superparamagnetism.

### Example 4 (not forming part of the invention)

A thin film of M-X-Y magnetic composition was made on a glass plate by the reactive sputtering method using the sputtering apparatus shown in Fig. 2A at a sputtering condition shown in Table 2. The partial pressure ratio of N₂ was 20%. The thin film was heat-treated at a temperature of 300°C for two hours in vacuum under magnetic field and obtained a film sample 4.

**Table 2**

| | |
|---|---|
| Vacuum degree before sputtering | <1 × 10⁻⁶ Torr (<1.33 × 10⁻⁴ Pa) |
| Atmosphere | Ar+N₂ gas |
| Electric Power | RF |
| Targets | Fe (diameter of 100mm) and Al chip (150 pieces) (chip size: 5mm × 5mm × 2mm) |

The properties of film sample 4 are show in Table 3.

**Table 3**

| | |
|---|---|
| Film thickness | 1.5 µ m |
| {Ms(M-X-Y)/Ms(M)} × 100 | 51.9% |
| µ"ₘₐₓ | 520 |
| f(µ"ₘₐₓ) | 830MHz |
| bwr | 175% |

### Example 5

A thin film of M-X-Y magnetic composition was made on a glass plate by using the sputtering apparatus shown in Fig. 2A at a sputtering condition shown in Table 4. The thin film was heat-treated at a temperature of 300°C for two hours in vacuum under magnetic field and obtained a film sample 5.

**Table 4**

| | |
|---|---|
| Vacuum degree before sputtering | <1 × 10⁻⁶ Torr (<1-33 × 10⁻⁴ Pa) |
| Atmosphere | Ar gas |
| Electric Power | RF |
| Targets | Co (diameter of 100mm) and Al₂O₃ chip (130 pieces) (chip size: 5mm × 5mm × 2mm) |

The properties of film sample 5 are show in Table 5.

**Table 5**

| | |
|---|---|
| Film thickness | 1.1 µm |
| {Ms(M-X-Y)/Ms(M)} × 100 | 64.7% |
| µ"ₘₐₓ | 850 |
| f(µ"ₘₐₓ) | 800MHz |
| bwr | 157% |

### Example 6 (not forming part of the invention)

A thin film of M-X-Y magnetic composition was made on a glass plate by the reactive sputtering method using the sputtering apparatus shown in Fig. 2A at a sputtering condition shown in Table 6. The partial pressure ratio of N₂ was 10%. The thin film was heat-treated at a temperature of 300°C for two hours in vacuum under magnetic field and obtained a film sample 6.

**Table 6**

| | |
|---|---|
| Vacuum degree before sputtering | <1 × 10⁻⁶ Torr (<1.33 × 10⁻⁴ Pa) |
| Atmosphere | Ar+N₂ gas |
| Electric Power | RF |
| Targets | Co (diameter of 100mm) and Al chip (170 pieces) (chip size: 5mm × 5mm × 2mm) |

The properties of film sample 6 are show in Table 7.

**Table 7**

| | |
|---|---|
| Film thickness | 1.2 µm |
| {Ms(M-X-Y)/Ms(M)} × 100 | 32.7% |
| µ"ₘₐₓ | 350 |
| f(µ"ₘₐₓ) | 1GHz |
| bwr | 191% |

### Example 7 (not forming part of the invention)

A thin film of M-X-Y magnetic composition was made on a glass plate by using the sputtering apparatus shown in Fig. 2A at a sputtering condition shown in Table 8. The thin film was heat-treated at a temperature of 300°C for two hours in vacuum under magnetic field and obtained a film sample 7.

**Table 8**

| | |
|---|---|
| Vacuum degree before sputtering | <1 × 10⁻⁶ Torr (<1.33 × 10⁻⁴ Pa) |
| Atmosphere | Ar gas |
| Electric Power | RF |
| Targets | Ni (diameter of 100mm) and Al₂O₃ chip (140 pieces) (chip size: 5mm × 5mm × 2mm) |

The properties of film sample 4 are show in Table 9.

**Table 9**

| | |
|---|---|
| Film thickness | 1.7 µm |
| {Ms(M-X-Y)/Ms(M)} × 100 | 58.2% |
| µ"ₘₐₓ | 280 |
| f(µ"ₘₐₓ) | 240MHz |
| bwr | 169% |

### Example 8

A thin film of M-X-Y magnetic composition was made on a glass plate by the reactive sputtering method using the sputtering apparatus shown in Fig. 2A at a sputtering condition shown in Table 10. The partial pressure ratio of N₂ was 10%. The thin film was heat-treated at a temperature of 300°C for two hours in vacuum under magnetic field and obtained a film sample 8.

**Table 10**

| | |
|---|---|
| Vacuum degree before sputtering | <1 × 10⁻⁶ Torr (<1.33 × 10⁻⁴ Pa) |
| Atmosphere | Ar+N₂ gas |
| Electric Power | RF |
| Targets | Ni (diameter of 100mm) and Al chip (100 pieces) (chip size: 5mm × 5mm × 2mm) |

The properties of film sample 10 are show in Table 11.

**Table 11**

| | |
|---|---|
| Film thickness | 1.3 µm |
| {Ms(M-X-Y)/Ms(M)} × 100 | 76.2% |
| µ"ₘₐₓ | 410 |
| f(µ"ₘₐₓ) | 170MHz |
| bwr | 158% |

### Example 9 (not forming part of the invention)

A thin film of M-X-Y magnetic composition was made on a glass plate by using the sputtering apparatus shown in Fig. 2A at a sputtering condition shown in Table 12. The thin film was heat-treated at a temperature of 300°C for two hours in vacuum under magnetic field and obtained a film sample 9.

**Table 12**

| | |
|---|---|
| Vacuum degree before sputtering | <1 × 10⁻⁶ Torr (<1.33 × 10⁻⁴ Pa) |
| Atmosphere | Ar gas |
| Electric Power | RF |
| Targets | Fe (diameter of 100mm) and TiO₂ chip (150 pieces) (chip size: 5mm × 5mm × 2mm) |

The properties of film sample 9 are show in Table 13.

**Table 13**

| | |
|---|---|
| Film thickness | 1.4 *µ*m |
| {Ms(M-X-Y)/Ms(M)} × 100 | 43.6% |
| *µ*"ₘₐₓ | 920 |
| f(*µ*"ₘₐₓ) | 1.5GHz |
| bwr | 188% |

### Example 10 (not forming part of the invention)

A thin film of M-X-Y magnetic composition was made on a glass plate by the reactive sputtering method using the sputtering apparatus shown in Fig. 2A at a sputtering condition shown in Table 14. The partial pressure ratio of O₂ was 15%. The thin film was heat-treated at a temperature of 300°C for two hours in vacuum under magnetic field and obtained a film sample 10.

**Table 14**

| | |
|---|---|
| Vacuum degree before sputtering | <1 × 10⁻⁶ Torr (<1.33 × 10⁻⁴ Pa) |
| Atmosphere | Ar+O₂ gas |
| Electric Power | RF |
| Targets | Fe (diameter of 100mm) and Si chip (130 pieces) (chip size: 5mm × 5mm × 2mm) |

The properties of film sample 10 are show in Table 15.

**Table 15**

| | |
|---|---|
| Film thickness | 1.5 u m |
| {Ms(M-X-Y)/Ms(M)} × 100 | 55.2% |
| µ"ₘₐₓ | 920 |
| f(µ"ₘₐₓ) | 1.2GHz |
| bwr | 182% |

### Example 11

A thin film of M-X-Y magnetic composition was made on a glass plate by using the sputtering apparatus shown in Fig. 2A at a sputtering condition shown in Table 16. The thin film was heat-treated at a temperature of 300°C for two hours in vacuum under magnetic field and obtained a film sample 11.

**Table 16**

| | |
|---|---|
| Vacuum degree before sputtering | <1 × 10⁻⁶ Torr (<1.33 × 10⁻⁴ Pa) |
| Atmosphere | Ar gas |
| Electric Power | RF |
| Targets | Fe (diameter of 100mm) and HfO₃ chip (100 pieces) (chip size: 5mm × 5mm × 2mm) |

The properties of film sample 11 are show in Table 17.

**Table 17**

| | |
|---|---|
| Film thickness | 1.8 µm |
| {Ms(M-X-Y)/Ms(M)} × 100 | 77.4% |
| µ"ₘₐₓ | 1800 |
| f(µ"ₘₐₓ) | 450MHz |
| bwr | 171% |

### Example 12 (not forming part of the invention)

A thin film of M-X-Y magnetic composition was made on a glass plate by using the sputtering apparatus shown in Fig. 2A at a sputtering condition shown in Table 18. The thin film was heat-treated at a temperature of 300°C for two hours in vacuum under magnetic field and obtained a film sample 12.

**Table 18**

| | |
|---|---|
| Vacuum degree before sputtering | <1 × 10⁻⁶ Torr (<1.33 × 10⁻⁴ Pa) |
| Atmosphere | Ar gas |
| Electric Power | RF |
| Targets | Fe (diameter of 100mm) and BN chip (130 pieces) (chip size: 5mm × 5mm × 2mm) |

The properties of film sample 12 are show in Table 19.

**Table 19**

| | |
|---|---|
| Film thickness | 1.9 *µ*m |
| {Ms(M-X-Y)/Ms(M)} × 100 | 59.3% |
| *µ*"ₘₐₓ | 950 |
| f(*µ*"ₘₐₓ) | 680MHz |
| bwr | 185% |

### Example 13 (not forming part of the invention)

A thin film of M-X-Y magnetic composition was made on a glass plate by using the sputtering apparatus shown in Fig. 2A at a sputtering condition shown in Table 20. The thin film was heat-treated at a temperature of 300°C for two hours in vacuum under magnetic field and obtained a film sample 13.

**Table 20**

| | |
|---|---|
| Vacuum degree before sputtering | <1 × 10⁻⁶ Torr (<1.33 × 10⁻⁴ Pa) |
| Atmosphere | Ar gas |
| Electric Power | RF |
| Targets | Fe₅₀Co₅₀ (diameter of 100mm) and Al₂O₃ chip (130 pieces) (chip size: 5mm × 5mm × 2mm) |

The properties of film sample 13 are show in Table 21.

**Table 21**

| | |
|---|---|
| Film thickness | 1.6 u m |
| {Ms(M-X-Y)/Ms(M)} × 100 | 59.3% |
| µ"ₘₐₓ | 720 |
| f(µ"ₘₐₓ) | 1.1 GHz |
| bwr | 180% |

### Example 14 (not forming part of the invention)

A thin film of M-X-Y magnetic composition was made on a glass plate by using the vapor deposition apparatus shown in Fig. 2B at a condition shown in Table 22. The thin film was heat-treated at a temperature of 300°C for two hours in vacuum under magnetic field and obtained a film sample 14.

**Table 22**

| | |
|---|---|
| Vacuum degree before sputtering | <1 × 10⁻⁶ Torr (<1.33 × 10⁻⁴ Pa) |
| Atmosphere flowing rate | O₂ at 3.0 sccm |
| Elements in crucible 28 and 29 | Fe and Al |

The properties of film sample 14 are show in Table 23.

**Table 23**

| | |
|---|---|
| Film thickness | 1.1 µm |
| {Ms(M-X-Y)/Ms(M)} × 100 | 41.8% |
| µ"ₘₐₓ | 590 |
| "f(µ" ₘₐₓ) | 520MHz |
| bwr | 190% |

Now, description will be made as to tests relating to noise suppressing effect of sample films and comparative samples, using a test apparatus shown in Fig. 6.

A test piece was film sample 1 with dimensions of 20mm × 20mm × 2.0 µm. For a comparison, a sheet of known composite magnetic material having dimensions of 20mm × 20mm × 1.0mm. The composite magnetic material comprising polymer and flat magnetic metal powder dispersed in the polymer. The magnetic metal powder comprises Fe, Al and Si. The composite magnetic material has a complex permeability distribution in quasi-microwave range and has the maximum value of the complex permeability at a frequency about 700 MHz. Table 24 shows magnetic properties of both of the test piece and comparative test piece.

**Table 24**

| | Film sample 1 | Comparative test piece |
|---|---|---|
| µ"/700MHz | about 1800 | about 3.0 |
| bwr | 148 | 196 |

As seen from Table 24, the film sample 1 is about 600 times more than comparative test piece in the maximum value of complex permeability. Since the noise suppressing effect is generally evaluated from a value of a product (µ"ₘₐₓ × *δ*) of the maximum complex permeability µ"ₘₐₓ and thickness of the piece δ, the thickness of the comparative test piece of the composite magnetic material sheet was selected 1mm so that the both of test pieces have the similar values of (µ"ₘₐₓ × δ).

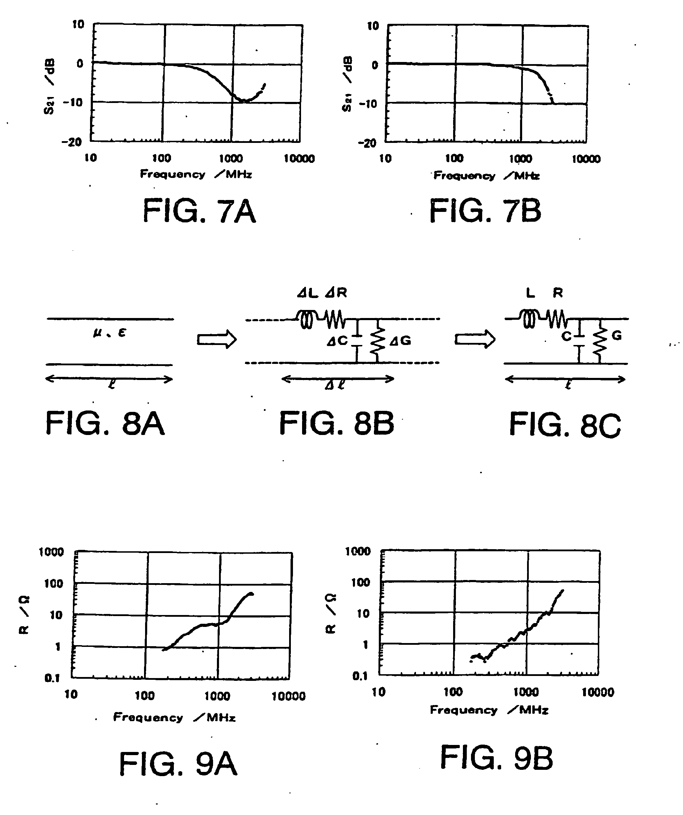

Referring to Fig. 6, the test apparatus comprises a micro-strip line 61 having two ports, coaxial cables 62 connected to the two ports, and a network analyzer (not shown) connected across the two ports. The micro-strip line 61 has a line length of 75mm and a characteristic impedance of 50 ohms. The test piece 63 was disposed at a region 64 on the micro-strip line 61 and the transmission characteristic S21 was measured. The frequency response of S21 are shown in Figs. 7A and 7b for film sample 1 and the comparative sample, respectively.

With respect to use of film sample 1, it will be noted from Fig. 7A that S21 reduces above 100 MHz, becomes to the minimum of -1 0dB at a frequency of 2 GHz and then increases above 2 GHz. On the other hand, with respect to use of comparative sample, it will be noted from Fig. 7B that S21 gradually reduces and becomes to the minimum of -10dB at a frequency of 3GHz.

The results demonstrate that S21 is dependent on the frequency distribution of the complex permeability and that the noise suppressing effect is dependent on the product of (µ"ₘₐₓ × *δ*)*.*

Now, providing that the magnetic sample forms a distribution constant circuit having a length of as shown in Fig. 8A, an equivalent circuit was calculated for a unit length of Δℓ from transmission characteristics S11 and S21, as shown in Fig. 8B. Then, the equivalent circuit for the length e was obtained from the equivalent circuit for the unit length Δℓ, as shown in Fig. 8C. The equivalent circuit of the magnetic sample comprises series inductance L and resistance R and parallel capacitance C and conductance G, as shown in Fig. 8C. From this, it will be understood that the change of transmission characteristic of the micro-strip line caused due to disposition of the magnetic substance on the micro-strip line is mainly determined by the equivalent resistance R added in series.

In view of the above, a frequency response of the equivalent resistance R was measured. The measured data were shown in Figs. 9A and 9B for the film sample 1 and the comparative sample, respectively. It will be noted from these figures that the equivalent resistance R gradually reduces in the quasi-microwave range and is about 60 ohms at about 3 GHz. It is seen that the frequency dependency of the equivalent resistance R is different from that of the complex permeability which has the maximum value at about 1 GHz. It will be supposed that this difference will be based on the gradual increase of a ratio of the product and the sample length to the wavelength.

Production method of the magnetic substance of this invention has been described as to the sputtering method and the vapor deposition method but they do not restrict the production method. Any other film producing method such as ion beam deposition method and gas deposition method can be used for production of the magnetic substance of the present invention if they can evenly produce the magnetic substance of the present invention. Further, the heat treatment after film production is not necessary if the film as produced has a sufficient property.

### Industrial Applicability

According to the present invention, the magnetic substance having a higher complex permeability in a high frequency such as a quasi-microwave range. Therefore, the magnetic substance according to the present invention can provide a noise suppressor which is useful in the small-sized electronic circuit elements and electronic apparatus.

## Claims

1. A noise suppressor comprising a magnetic substance which is a plate having a thickness of 0.3 - 20 µm and which is of a magnetic composition comprising M, X and Y;
where M is a metallic magnetic material consisting of at least one of Fe, Co, and Ni; Y is at least one of F, N and O; and
X is element or elements other than M and Y, wherein the M-X-Y magnetic composition has a saturation magnetization of 60-80% of that of a metallic bulk of magnetic material comprising M alone,
wherein the M-X-Y magnetic composition has a concentration of M so that the M-X-Y magnetic composition has the aforementioned saturation magnetization, the magnetic composition having the maximum µ"ₘₐₓ of complex permeability µ" in a frequency range of 0.1-10 gigahertz (GHz),
wherein the magnetic substance has a complex permeability frequency response of a frequency band where a relative bandwidth bwr is 200% or less, the relative bandwidth bwr is determined as a percentage ratio of bandwidth between two frequency points which shows the complex permeability as a half value µ"₅₀ of the maximum µ"ₘₐₓ, to center frequency of the bandwidth.

2. The noise suppressor according to claim 1, wherein the magnetic substance has a DC specific resistance of 100-700 µΩ*cm.

3. The noise suppressor according to one of claims 1 and 2, wherein X comprises at least one of C, Bi, Si, Al, Mg, Ti, Zn, Hf, Sr, Nb, Ta and a rare-earth metal.

4. The noise suppressor according to one of claims 1-3, wherein the metallic magnetic material M is distributed as granular grains in a matrix composition consisting of X and Y

5. The noise suppressor according to claim 4, wherein the granular grains have an average grain size of 1-40nm.

6. The noise suppressor according to one of claims 1-5, wherein the magnetic substance has an anisotropy field of 47746 A/m (600Oe) or less.

7. The noise suppressor according to one of claims 1-6, wherein the magnetic composition is a composition represented by a formula of Fe_{α}-Al_{β}-O_{γ}.

8. The noise suppressor according to one of claims 1-16, wherein the magnetic composition is a composition represented by a formula of Fe_{α}-Si_{β}-O_{γ}.

9. The noise suppressor according to one of claims 1-18, wherein the magnetic substance is a thin film obtainable by sputtering process.

10. The noise suppressor according to one of claims 1-18, wherein the magnetic substance is a thin film obtainable by vapor deposition process.

## Patentansprüche

1. Rauschunterdrücker, umfassend eine magnetische Substanz, die eine Platte mit einer Dicke von 0,3 - 20µm darstellt und die eine magnetische, M, X und Y umfassende Zusammensetzung ist;
worin M ein metallisches magnetisches Material ist, das aus mindestens Einem von Fe, Co und Ni zusammengesetzt ist;
Y mindestens Eines von F, N und O ist;
X ein Element oder Elemente darstellt, das bzw. die von M und Y verschieden ist bzw. sind,
wobei die magnetische Zusammensetzung M-X-Y eine Sättigungsmagnetisierung von 60 - 80% derjenigen einer metallischen Masse von magnetischem Material aufweist, das M allein aufweist,
wobei die magnetische M-X-Y-Zusammensetzung eine Konzentration von M derart aufweist, dass die magnetische M-X-Y-Zusammensetzung die vorerwähnte Sättigungsmagnetisierung aufweist, wobei die magnetische Zusammensetzung das Maximum µ"ₘₐₓ der komplexen Permeabilität µ" in einem Frequenzbereich von 0,1 - 10 Gigaherz (GHz) aufweist,
wobei die magnetische Substanz eine komplexe Permeabilitätsfrequenzantwort eines Frequenzbandes aufweist, bei der die relative Bandbreite bwr 200% oder weniger ist, wobei die relative Bandbreite bwr bestimmt ist als ein Prozentverhältnis der Bandbreite zwischen zwei Frequenzpunkten, die die komplexe Permeabitität als ein Halbwert µ''₅₀ des Maximums µ''ₘₐₓ zeigen, zu der mittleren Frequenz der Bandbreite.

2. Rauschunterdrücker gemäß Anspruch 1, wobei die magnetische Substanz einen spezifischen Gleichstromwiderstand von 100-700 µΩ x cm aufweist.

3. Rauschunterdrücker gemäß einem der Ansprüche 1 und 2, wobei X mindestens Eines.von C, Bi, Si, Al, Mg, Ti, Zn, Hf, Sr, Nb, Ta und Seltenerdmetall umfasst.

4. Rauschunterdrücker gemäß einem der Ansprüche 1-3, wobei das metallische magnetische Material M als granulöse Körnchen in einer Matrixzusammensetzung, die aus X und Y besteht, verteilt ist.

5. Rauschunterdrücker gemäß Anspruch 4, wobei die granulösen Körnchen eine mittlere Körnchengröße von 1-40 nm aufweisen.

6. Rauschunterdrücker gemäß einem der Ansprüche 1 - 5, wobei die magnetische Substanz ein anisotropes Feld von 47.746 A/m (600 Oe) oder weniger aufweist.

7. Rauschunterdrücker gemäß einem der Ansprüche 1 - 6, wobei die magnetische Zusammensetzung eine Zusammensetzung ist, die durch eine Formel Fe_{α}-Al_{β}-O_{γ} dargestellt ist.

8. Rauschunterdrücker gemäß einem der Ansprüche 1 - 6, wobei die magnetische Zusammensetzung eine Zusammensetzung ist, die durch eine Formel Fe_{α}-Si_{β}-O_{γ} dargestellt ist.

9. Rauschunterdrücker gemäß einem der Ansprüche 1 - 8, wobei die magnetische Substanz ein dünner Film ist, der durch einen Sputter-Prozeß erhältlich ist.

10. Rauschunterdrücker gemäß einem der Ansprüche 1 - 8, wobei die magnetische Substanz ein dünner Film ist, der durch einen Dampfabscheidungsprozeß erhältlich ist.

## Revendications

1. Suppresseur de bruit contenant une substance magnétique qui est une plaque ayant une épaisseur de 0,3-20 µm et qui a une composition magnétique comprenant M, X et Y;
M étant un métal magnétique correspondant à au moins l'un des éléments Fe, Co et Ni;
Y étant au moins l'un des éléments F, N et O, et
X étant un ou des éléments autres que M et Y, la composition magnétique M-X-Y ayant une aimantation de saturation de 60-80% de celle d'un métal magnétique en vrac contenant M seul,
la composition magnétique M-X-Y ayant une concentration de M telle que la composition magnétique M-X-Y présente l'aimantation de saturation susmentionnée, la composition magnétique ayant le maximum µ"ₘₐₓ de perméabilité complexe µ" sur une plage de fréquences de 0,1 à 10 gigahertz (GHz), et
la substance magnétique ayant une perméabilité complexe de fréquence pour une bande de fréquence d'une largeur de bande relative bwr égale à 200% ou moins, la largeur de bande relative bwr étant déterminée comme pourcentage de la largeur de bande entre deux points de fréquence présentant la perméabilité complexe de valeur moitié µ"₅₀ par rapport au maximum µ"ₘₐₓ vis-à-vis de la fréquence centrale de la largeur de bande.

2. Suppresseur de bruit selon la revendication 1, dans lequel la substance magnétique a une résistance spécifique continue de 100-700 µΩ*cm.

3. Suppresseur de bruit selon l'une des revendications 1 et 2, dans lequel X correspond à au moins l'un des éléments C, Bi, Si, Al, Mg, Ti, Zn, Hf, SR, Nb, Ta et un métal de terres rares.

4. Suppresseur de bruit selon l'une des revendications 1 à 3, dans lequel le métal magnétique M est réparti sous la forme de grains dans une matrice formée de X et Y.

5. Suppresseur de bruit selon la revendication 4, dans lequel les grains ont une dimension moyenne de grain de 1-40 nm.

6. Suppresseur de bruit selon l'une des revendications 1 à 5, dans lequel la substance magnétique présente un champ anisotrope de 47746 A/m (600 Oe) ou moins.

7. Suppresseur de bruit selon l'une des revendications 1 à 6, dans lequel la composition magnétique est représentée par la formule Fe_{α}-Al_{β}-O_{γ}.

8. Suppresseur de bruit selon l'une des revendications 1 à 6, dans lequel la composition magnétique est représentée par la formule Fe_{α}-Si_{β}-O_{γ}.

9. Suppresseur de bruit selon l'une des revendications 1 à 8, dans lequel la substance magnétique est un film mince obtenu par pulvérisation.

10. Suppresseur de bruit selon l'une des revendications 1 à 8, dans lequel la substance magnétique est un film mince obtenu par un procédé de dépôt à la vapeur.
